# EUROPÄISCHE PATENTSCHRIFT

(11) **EP 2 734 388 B1**
(45) Veröffentlichungstag und Bekanntmachung des Hinweises auf die Patenterteilung: **23.03.2016**
(21) Anmeldenummer: 13715678.2
(22) Anmeldetag: 10.04.2013
(51) Int. Cl.: G01M 17/02, H01L 41/047, H01L 41/113, B60C 23/04, H02N 2/18

(54) **REIFENMODUL MIT PIEZOELEKTRISCHEM WANDLER UND DAMIT AUSGESTATTETER REIFEN**
TYRE MODULE WITH PIEZOELECTRIC CONVERTER AND PNEUMATIC TIRE USING SAME
MODULE DE PNEU À TRANSDUCTEUR PIÉZOÉLECTRIQUE ET PNEU AVEC CE MODULE

(30) Priorität: 11.04.2012 DE 102012007071; 17.08.2012 DE 102012107573
(43) Veröffentlichungstag der Anmeldung: 28.05.2014
(73) Patentinhaber: Huf Hülsbeck & Fürst GmbH & Co. KG, 42551 Velbert (DE)
(72) Erfinder: DUSSINGER, Axel, 74906 Bad Rappenau (DE); KESSLER, Ralf, 76327 Pfinztal (DE); WOLF, Ingemar, 68753 Waghäusel (DE); SEIFERT, Andre, 75181 Pforzheim (DE); MÜLLER, Benjamin, 74177 Bad Friedrichshall (DE)
(74) Vertreter: Twelmeier Mommer & Partner
(86) Internationale Anmeldenummer: PCT/EP2013/057446
(87) Internationale Veröffentlichungsnummer: WO 2013/153088

(56) Entgegenhaltungen:
- WO-A1-95/15577
- WO-A1-2008/034825
- DE-T2- 60 310 104
- US-A1- 2011 127 881

## Beschreibung

Die Erfindung geht von einem Reifenmodul mit den im Oberbegriff des Anspruchs 1 angegebenen Merkmalen aus. Ein solches Reifenmodul ist aus der DE 603 10 104 T2 bekannt. Das bekannte Reifenmodul wird an der Innenseite eines Luftreifens für Fahrzeuge angebracht. Es enthält eine Einrichtung zum Messen und/oder Überwachen des Luftdrucks in dem Reifen und einen Sender zum Übertragen von Funksignalen, welche eine Information über den Luftdruck im Reifen enthalten. Die elektrische Energie, welche das Reifenmodul benötigt, wird von einem mechanisch-elektrischen Wandler mit einem biegbaren piezoelektrischen Element geliefert, welches Beschleunigungskräften ausgesetzt ist, die bei rollendem Reifen von einer seismischen Masse ausgeübt werden und sich am Beginn und am Ende eines Durchlaufs des Reifenmoduls durch die Aufstandsfläche des Reifens (Latsch) ändern. Die vom piezoelektrischen Element erzeugte elektrische Energie steigt mit der Größe der seismischen Masse und mit der Drehzahl des Reifens. Die vom Piezoelement gelieferte elektrische Energie wird einem Speicher zugeführt, aus welchem sie zum Betreiben der Einrichtung zum Messen und/oder Überwachen des Luftdrucks und zum Betreiben des Senders entnommen werden kann. Der den Piezoeffekt ausnutzende mechanisch-elektrische Wandler kann eine sonst im Reifenmodul erforderliche langlebige Batterie ersetzen.

Auch die WO 2008/034825 A1, die DE 603 10 104 T2, die WO 2010/092171 A2, die WO 2007/099159 A1 und die DE 10 2004 031 810 A1 offenbaren Reifenmodule mit einem Piezoelement, welches durch Kräfte beaufschlagt wird, mit welcher Zentrifugalbeschleunigungen auf eine seismische Masse einwirken, die mit dem Piezoelement verbunden ist. Die US 2007/0074566 A1 offenbart ein Reifenmodul mit einem Piezoelement, welches aus den auftretenden Reifendruckschwankungen elektrische Energie erzeugt.

Der vorliegenden Erfindung liegt die Aufgabe zugrunde, ein besonders leicht zu montierendes und hinsichtlich seiner Stromversorgung autarkes Reifenmodul zu schaffen.

Diese Aufgabe wird durch ein Reifenmodul mit den im Anspruch 1 angegebenen Merkmalen gelöst. Gegenstand der Erfindung ist weiterhin ein Reifen, der mit einem solchen Reifenmodul ausgestattet ist. Vorteilhafte Weiterbildungen der Erfindung sind Gegenstand der Unteransprüche.

Das erfindungsgemäße Reifenmodul hat eine Einrichtung zum Messen und/oder Überwachen des Luftdrucks in dem Reifen, einen Sender zum Übertragen von Funksignalen, welche eine Information über den Luftdruck im Reifen enthalten, einen mechanischelektrischen Wandler mit einem biegbaren piezoelektrischen Element, welches vom rollenden Reifen verursachte wechselnde Verformungen des piezoelektrischen Elementes in elektrische Energie wandelt, und einen Speicher für die elektrische Energie, welcher mit dem Wandler verbunden ist. Der Wandler enthält ein kreisförmiges, scheibenförmiges, piezoelektrisches Element, welches nachfolgend als Piezoscheibe bezeichnet ist und an welchem eine durch den Piezoeffekt erzeugte elektrische Spannung an Kontaktstellen abgegriffen wird, die sich auf gegenüberliegenden Seiten der Piezoscheibe befinden.

Das erfindungsgemäße Reifenmodul hat wesentliche Vorteile:
- Durch die Verwendung eines kreisförmigen, scheibenförmigen, piezoelektrischen Elements kann das Reifenmodul, welches zweckmäßigerweise so angeordnet wird, dass die Mittelachse der kreisförmigen Piezoscheibe senkrecht zur Lauffläche des Reifens und damit radial in Bezug auf die Drehachse des Reifens ausgerichtet ist, im übrigen in beliebiger Orientierung an der Innenseite des Reifens befestigt werden. Drehungen des Reifenmoduls um die Mittelachse der kreisförmigen Piezoscheibe bleiben ohne nennenswerten Einfluss auf den Wirkungsgrad des mechanisch-elektrischen Wandlers.
- Die Verwendung einer kreisförmigen Piezoscheibe erlaubt die Verwendung eines flachen, zylindrischen Gehäuses für das Reifenmodul, dessen Durchmesser sich am Durchmesser der Piezoscheibe orientiert. Das ermöglicht einen besonders kompakten Aufbau des Reifenmoduls mit minimaler Masse.
- Minimale Masse bedeutet minimale Unwucht und minimale Trägheitskräfte, welche ihrerseits eine lange Lebensdauer begünstigen.
- Ein Reifenmodul mit flachem, zylindrischem Gehäuse lässt sich besonders leicht handhaben und leicht und dauerhaft an der Innenseite des Reifens befestigen.
- Zweckmäßigerweise wird das Reifenmodul im Bereich der Mitte der Lauffläche an der Innenseite des Reifen befestigt. Eine falsche Anordnung des erfindungsgemäßen Reifenmoduls ist dort nicht möglich.
- Auch bei sich langsam drehendem Reifen liefert das Reifenmodul genügend Energie für die Reifendruckkontrolle, denn die Erzeugung der Piezospannung hängt nicht davon ab, dass eine Zentrifugalbeschleunigung auf eine seismische Masse einwirkt.

Das kreisförmige, scheibenförmige, piezoelektrische Element besteht vorzugsweise aus einer Piezokeramik, z. B. aus Bleizirkonattitanat. Das piezoelektrische Element kann aber auch gebildet werden, indem ein Substrat, insbesondere ein metallisches Substrat, mit einem piezoelektrischen Material beschichtet wird. In diesem Fall dient das Substrat als Träger für das piezoelektrische Material. Für beide Ausführungsformen wird in dieser Patentbeschreibung der Begriff "Piezoscheibe" verwendet. Die Piezoscheibe wird im Reifenmodul so montiert, dass Formänderungen der Lauffläche des Reifens Formänderungen der Piezoscheibe erzeugen, welche insbesondere beim Latscheinlauf und beim Latschauslauf auftreten. Die wechselnden Formänderungen erzeugen auf der Piezoscheibe eine elektrische Spannung, die an Kontaktstellen abgegriffen werden kann, die sich auf gegenüberliegenden Seiten der Piezoscheibe befinden.

Eine der Kontaktstellen, welche für das Abgreifen der elektrischen Spannung verwendet wird, ist vorzugsweise durch eine Metallscheibe, insbesondere durch eine kreisförmige Metallscheibe, gebildet, welche eine erste Seite der Piezoscheibe vollständig bedeckt. Die Metallscheibe ist so dünn und biegsam, dass sie das erwünschte Biegen der Piezoscheibe beim Latschdurchlauf erlaubt und das piezoelektrische Material schützt, insbesondere gegen Bruch. Die Metallscheibe kann eine Außenseite des Reifenmoduls bilden, so dass das Reifenmodul nach seiner Befestigung an einem Reifen mit seiner Metallscheibe an der Innenseite des Reifens anliegt. Das hat den Vorteil, dass die dort auftretenden Verformungen des Reifens unmittelbar auf die Metallscheibe und von dieser auf die Piezoscheibe übertragen werden. In der Ausführungsform, in welcher ein metallisches Substrat mit piezoelektrischem Material beschichtet ist, kann das metallische Substrat als die eine Kontaktstelle der Piezoscheibe verwendet werden. Eine gesonderte Metallscheibe ist in diesem Fall entbehrlich, um eine elektrische Kontaktstelle zu bilden. Nach der Befestigung des Reifenmoduls am Reifen kann das metallische Substrat bzw. eine Metallscheibe, welche eine der zwei elektrischen Kontaktstellen bildet, unmittelbar an der Innenseite des Reifens anliegen oder von der Innenseite des Reifens durch eine Zwischenlage getrennt sein, welche so dünn und biegsam ist, dass die beim Latschdurchlauf auftretende Verformung der Innenseite des Reifens auf die Piezoscheibe übertragen wird und diese zur Erzeugung der für den Betrieb des Reifenmoduls ausreichenden elektrischen Energie veranlasst.

Vorzugsweise hat die Metallscheibe, welche eine erste Seite der Piezoscheibe vollständig bedeckt und als elektrische Kontaktstelle benutzt wird, einen etwas größeren Durchmesser als die Piezoscheibe.

Die zweite Seite der Piezoscheibe wird vorzugsweise nur teilweise mit einer oder mehreren Kontaktstellen versehen. Das erleichtert es, dafür zu sorgen, dass der aus der Piezoscheibe, der kontaktgebenden Metallscheibe auf der ersten Seite der Piezoscheibe und dem elektrischen Kontaktmaterial auf der zweiten Seite der Piezoscheibe gebildete Verbundkörper eine neutrale Faser hat, die beim Biegen der Piezoscheibe nicht in der Mitte der Piezoscheibe liegt, sondern am Rand der Piezoscheibe oder gar in der Metallscheibe. Das ist von Bedeutung für einen guten Wirkungsgrad des mechanisch-elektrischen Wandlers auf Piezobasis.

Vorzugsweise sind auf der zweiten Seite der Piezoscheibe mehrere Kontaktstellen vorgesehen, welche elektrisch leitend miteinander verbunden sind. Das stellt sicher, dass der mechanisch-elektrische Wandler nicht schon dann ausfällt, wenn sich eine der Kontaktstellen von der Piezoscheibe ablösen sollte. Die eine bzw. die mehreren Kontaktstellen auf der zweiten Seite der Piezoscheibe sind vorzugsweise mittig auf der Piezoscheibe angeordnet und bedecken zweckmäßigerweise nicht mehr als 20 %, vorzugsweise höchstens 10 % der Oberfläche der zweiten Seite der Piezoscheibe.

Vorzugsweise ist die Piezoscheibe zwischen der Metallscheibe auf der ersten Seite der Piezoscheibe und einer flexiblen Leiterbahnfolie auf der zweiten Seite der Piezoscheibe angeordnet. Auf der flexiblen Leiterbahnfolie befinden sich Leiterbahnen, die zu den Kontaktstellen auf der zweiten Seite der Piezoscheibe führen und diese gegebenenfalls miteinander und mit dem im Reifenmodul vorgesehenen Speicher für die elektrische Energie verbinden. Die Leiterbahnfolie kann auch eine Leiterbahn haben, welche die elektrische Verbindung zwischen der Metallscheibe auf der ersten Seite der Piezoscheibe und dem Speicher für die elektrische Energie herstellt. Die Verbindung zwischen den Leiterbahnen und der Metallscheibe auf der ersten Seite der Piezoscheibe und den Kontaktstellen auf der zweiten Seite der Piezoscheibe kann z. B. durch Reflow-Löten hergestellt werden. Dabei können zwischen der Metallscheibe und der mit ihr zu verbindenden Leiterbahn der Leiterbahnfolie aus Sicherheitsgründen mehrere Lötstellen ausgebildet sein. Vorzugsweise verläuft die Leiterbahn, durch welche die Verbindung mit der kreisförmigen Metallscheibe hergestellt wird, am Rand der Kreisscheibe und erstreckt sich nahezu über den gesamten Umfang der Kreisscheibe.

Die Leiterbahnfolie kann - wie eine Leiterplatte - Leiterbahnen auf beiden Seiten der Leiterbahnfolie aufweisen. Das ist eine Möglichkeit, um die Leiterbahn, die zur ersten Seite der Piezoscheibe führt, von den Leiterbahnen, die zu den Kontaktstellen auf der zweiten Seite der Piezoscheibe führen, elektrisch zu isolieren. Die Leiterbahnen können aber auch auf ein und derselben Seite der Leiterbahnfolie verlaufen. Soweit sie dabei über einen Randbereich der kreisförmigen Metallscheibe führen, können sie dort durch einen elektrisch isolierenden Lack voneinander isoliert werden.

Die Metallscheibe soll an der Scheibe aus piezoelektrischem Material haften. Das kann z. B. mit Hilfe eines Leitklebers erfolgen. Ein Leitkleber ist ein Klebstoff, in welchem elektrisch leitfähige Pigmente verteilt sind, die dem Leitkleber eine elektrische Leitfähigkeit verleihen. Wenn die Metallscheibe mit der keramischen Piezoscheibe durch Kleben oder auf andere Weise fest verbunden ist, genügt es, wenn die keramische Piezoscheibe hauptsächlich in einer Richtung polarisiert ist, damit beim Biegen des Verbundes aus der keramischen Piezoscheibe und der biegsamen Metallscheibe durch den Piezoeffekt eine nutzbare elektrische Spannung erzeugt wird. Ohne den Verbund mit einer biegsamen Metallscheibe würde man einen Verbund aus wenigstens zwei entgegengesetzt polarisierten keramischen Piezoscheiben benötigen, um durch den Piezoeffekt beim Biegen eine nutzbare elektrische Spannung zu erzeugen.

Die Leiterbahnfolie, welche die erste Seite der Piezoscheibe bedeckt, bildet vorzugsweise eine Kreisfläche, welche durch einen Steg, der vorzugsweise ebenfalls aus der Leiterbahnfolie besteht und vom Rand der Kreisfläche ausgeht, mit einem Schaltungträger verbunden ist. Der Schaltungsträger besteht vorzugsweise ebenfalls aus der Leiterbahnfolie, so dass er und die Kreisfläche, welche die erste Seite der Piezoscheibe bedeckt, in einem Stück aus der flexiblen Leiterbahnfolie gebildet sein können. Das ist günstig für einen leichten, preiswerten und kompakten Aufbau des Reifenmoduls. Der Aufbau ist dann besonders kompakt, wenn die beiden Kreisflächen, welche im Durchmesser vorzugsweise übereinstimmen, unter Zwischenfügen einer steifen Distanzscheibe, vorzugsweise einer starren Distanzscheibe, welche vorzugsweise ebenfalls kreisförmig ist, übereinander und vorzugsweise koaxial zueinander angeordnet sind. In diese Lage können die beiden Kreisflächen dadurch gebracht werden, dass die Leiterbahnfolie im Bereich des Stegs unter Zwischenfügen der Distanzscheibe um diese umgeschlagen wird. Die Piezoscheibe, die Distanzscheibe und der Teil der Leiterbahnfolie, welcher den Schaltungsträger bildet und mit den Bauelementen und Schaltungsteilen des Reifenmoduls bestückt ist, sind auf diese Weise besonders kompakt übereinander angeordnet und können von einem Gehäuse mit zylindrischer Mantelfläche aufgenommen werden, wobei sich der Durchmesser der Mantelfläche des Gehäuses am Durchmesser der Piezoscheibe und der vorzugsweise etwas größeren Metallscheibe orientiert, welche die Piezoscheibe trägt.

Die Distanzscheibe ist auf ihrer der Piezoscheibe zugewandten Seite vorzugsweise konvex gewölbt. Das hat den Vorteil, dass auf diese Weise ein Freiraum gebildet wird, in welchen hinein der Rand der Piezoscheibe gebogen werden kann. Die Größe dieses Freiraums ist zweckmäßigerweise so gewählt, dass die gebogene Piezoscheibe der ihr zugewandten konvexen Seite der Distanzscheibe flächig anliegt, bevor sie brechen kann.

Zweckmäßigerweise sind die Bestandteile des Reifenmoduls, mit Ausnahme des Freiraums zwischen der konvexen Seite der Distanzscheibe und der ihr zugewandten Kreisfläche sowie mit Ausnahme der der Piezoscheibe abgewandten Seite der Metallscheibe in eine elektrisch isolierende Vergussmasse eingebettet. Die Vergussmasse schützt die Bestandteile des Reifenmoduls gegen Staub und insbesondere gegen das Eindringen von Feuchtigkeit. Um zu verhindern, dass die Vergussmasse in den Freiraum zwischen der konvexen Seite der Distanzscheibe und der ihr zugewandten Seite der Leiterbahnfolie eindringt, ist zwischen der Distanzscheibe und der von der Leiterbahnfolie gebildeten Kreisfläche, welche der Piezoscheibe zugewandt ist, ein Dichtring vorgesehen, welcher vorzugsweise einen rechteckigen Querschnitt hat. Der Dichtring besteht vorzugsweise aus einem kompressiblen Schaumstoff.

Wenn sich die Vergussmasse nach dem Vergießen der Bestandteile des Reifenmoduls verfestigt hat, hat sie vorzugsweise eine im wesentlichen zylindrische Umfangsfläche. "Im wesentlichen" ist hier so zu verstehen, dass die Gestalt der Umfangsfläche von der idealen Zylinderform abweichen kann, um das vergossene Reifenmodul entformen zu können, wenn das Vergießen in einer Gießform stattfindet, aus welcher man das Modul nach dem Verfestigen der Vergussmasse entnehmen muss, wenn sich die Gießform nicht als "verlorene" Form eignet. Für das Entformen ist eine das Entformen erleichternde geringe Konizität der Gießform zweckmäßig.

Vorzugsweise ist eine Kappe vorgesehen, in welche das vergossene Reifenmodul eingesetzt wird. An ihrem Rand hat diese Kappe vorzugsweise einen nach außen weisenden Flansch, mit welchem die Kappe an der Innenseite des Reifens befestigt werden kann. Die Kappe ist zweckmäßigerweise ein vorgefertigtes Formteil. Damit sie das vergossene Reifenmodul spielfrei aufnimmt, hat die Umfangsfläche der Vergussmasse des Reifenmoduls gegenüber der lichten Weite der leeren Kappe vorzugsweise ein Übermaß, so dass die Kappe ein wenig gedehnt wird, wenn das Reifenmodul in sie eingesetzt wird. Vorzugsweise hat auch die Höhe des Reifenmoduls gegenüber der lichten Höhe der Kappe ein Übermaß, so dass die Kappe auch in der Höhe ein wenig gedehnt wird, wenn sie mit dem eingesetzten Reifenmodul an der Innenseite des Reifens befestigt wird. Dieses Befestigen kann auf unterschiedliche Weise geschehen, z. B. dadurch, dass der Flansch der Kappe auf die Innenseite des Reifens vulkanisiert, insbesondere kalt vulkanisiert wird. Eine andere Möglichkeit besteht darin, den Flansch der Kappe mit der Innenseite des Reifens zu verkleben, z. B. mit einem Hot-melt.

Die Kappe besteht zweckmäßigerweise aus einem elastomeren Werkstoff, insbesondere aus einem Werkstoff auf Kautschukbasis.

In die Kappe wird das vergossene Reifenmodul vorzugsweise zusammen mit der Gießform eingesetzt, in welcher das Reifenmodul vergossen wird. Die Gießform ist in diesem Fall eine "verlorene" Form. Damit sie sich für diesen Zweck eignet, ist sie vorzugsweise als eine Wanne ausgebildet, die einen Boden hat, der so angeordnet wird, dass er bei montiertem Reifenmodul der Innenseite des Reifens anliegt und der so dünn ist, dass er die Verformung der Innenseite des Reifens mitmacht und auf die Piezoscheibe überträgt, während diese sich bei rollendem Reifen an dessen Latsch vorbeibewegt. Die Wanne besteht vorzugsweise aus einer Kunststofffolie und ist zweckmäßigerweise durch Tiefziehen oder durch Warmumformen aus der Kunststofffolie gebildet. Die Verwendung der Gießform als verlorene Form hat mehrere Vorteile: Das Reifenmodul hat nach dem Vergießen eine genau definierte Form und für die Wanne kann ein Material gewählt werden, welches auf der Innenseite des Reifens nicht haftet, sondern bei den wechselnden Verformungen des Reifens auf der Innenseite des Reifens gleitet.

Wenn das Reifenmodul eine Einrichtung zum Messen des Luftdrucks im Reifen haben soll, dann muss die Luft im Reifen Zugang zum Inneren des Reifenmoduls haben. Es ist bekannt, zum Messen des Luftdrucks im Reifen einen integrierten Schaltkreis vorzusehen, in welchen ein elektrischer Drucksensor, insbesondere auf Siliziumbasis, integriert ist. Ein solcher integrierter Schaltkreis hat eine Öffnung, welche den Zutritt der unter Druck stehenden Luft zum Drucksensor ermöglicht, wobei diese Öffnung zum Schutz vor Verschmutzungen ein Filterelement enthalten kann. Über einer solchen Öffnung ist sowohl in der Vergussmasse als auch in der Kappe ein Zugang offen zu lassen, über welchen der Drucksensor mit der Druckluft im Reifen in Verbindung steht. Der Drucksensor muss aber nicht ein Bestandteil eines integrierten Schaltkreises sein, er kann auch als eigenständiges Bauteil auf der Leiterbahnfolie angebracht sein.

In vorteilhafter Weiterbildung der Erfindung enthält das Reifenmodul nicht nur einen Sender mit einer Sendeantenne, sondern auch einen Empfänger mit einer Empfangsantenne. Während der Sender üblicherweise mit Frequenzen oberhalb von 100 MHz sendet, ist der Empfänger im Reifenmodul vorzugsweise für eine wesentlich niedrigere Frequenz ausgelegt, insbesondere für eine Frequenz von 125 KHz. Von dieser Empfangsantenne können Signale empfangen werden, welche eine Information transportieren, z. B. Signale zum Einstellen und/oder Programmieren einer im Reifenmodul vorgesehenen Steuerschaltung, welche z. B. ein Mikroprozessor, ein Mikrocontroller oder ein ASIC sein kann. Über diese Empfangsantenne können auch Signale empfangen werden, welche Daten enthalten, die den Reifen selbst charakterisieren, z. B. nach Typ und Jahr der Herstellung, und welche das Reifenmodul charakterisieren, z. B. eine individuelle Kennung, nämlich ein Code, der jedes Mal mitgesandt wird, wenn das Reifenmodul ein Signal aussendet, so dass der Empfänger dieses Signals anhand der mit übertragenen Kennung feststellen kann, von welchem Reifenmodul das Signal kommt.

Über die niederfrequente Empfangsantenne des Reifenmoduls kann aber auch per Funk übertragene elektrische Energie zum Laden des Speichers im Reifenmodul empfangen werden. Das ist von Vorteil, wenn das Fahrzeug so lange stillgestanden ist, dass sich der im Reifenmödul vorgesehene Speicher für elektrische Energie entladen hat. So kann der Speicher z. B. bei Wartungsarbeiten in einer Werkstatt aufgeladen werden, wo es nicht möglich ist, mit dem piezoelektrisch arbeitenden mechanisch-elektrischen Wandler den Speicher aufzuladen.

Weitere Vorteile und Merkmale der Erfindung ergeben sich aus der nachfolgenden Beschreibung eines Ausführungsbeispiels der Erfindung.
- Figur 1: zeigt ein erfindungsgemäßes Reifenmodul in einer Explosionsdarstellung, und zwar in Schrägansicht, zusammen mit einer Kappe, welche das Reifenmodul aufnehmen soll,
- Figur 2: zeigt das Reifenmodul aus Figur 1, eingebettet in eine Vergussmasse und eingesetzt in die Kappe, in einem vereinfachten Schnitt durch die Mittelachse der Kappe,
- Figur 3: zeigt das Reifenmodul in einem vereinfachten Schnitt wie in Figur 2, befestigt an der Innenseite eines Reifens,
- Figur 4: zeigt eine Draufsicht auf die aufgeklappte, mit Bauelementen des Reifenmoduls bestückte Leiterbahnfolie,
- Figur 5: zeigt ein vereinfachtes Blockschaltbild der im Reifenmodul untergebrachten elektrischen Schaltung, und
- Figur 6: zeigt einen vereinfachten Schnitt durch ein Reifenmodul, welches als integralen Bestandteil eine Wanne als verlorene Gießform aufweist.

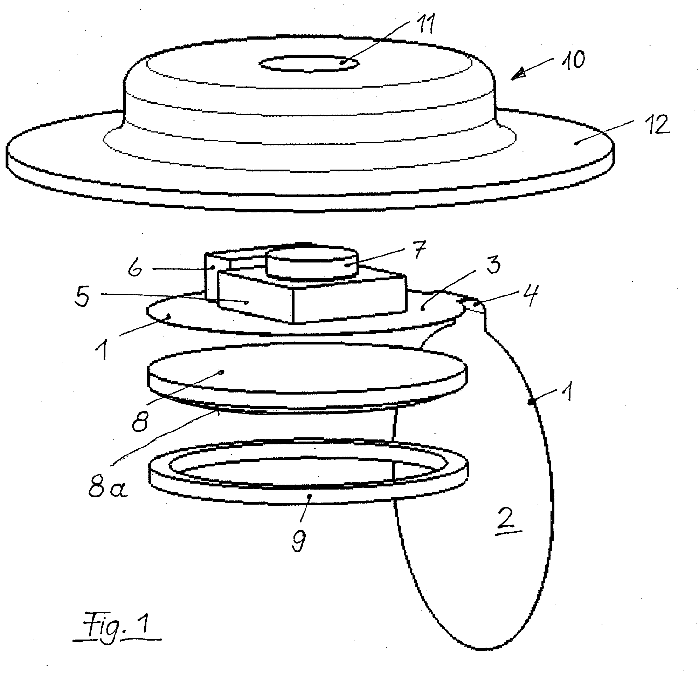

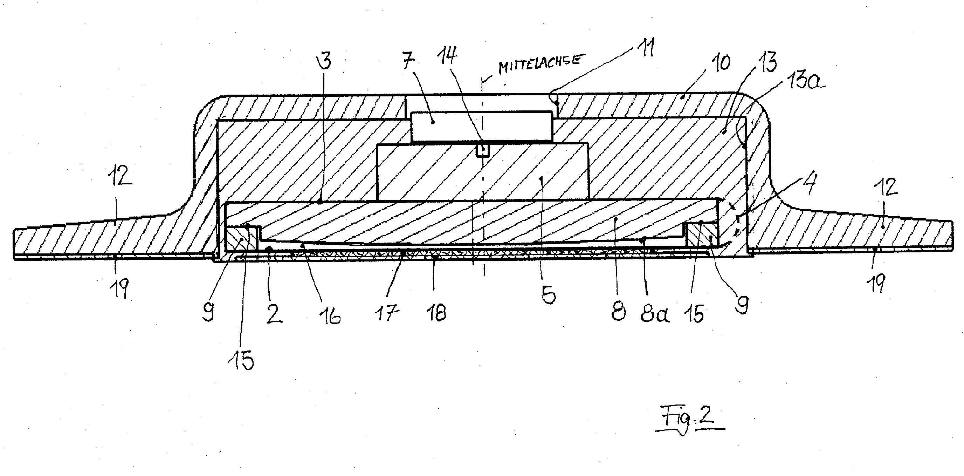

Figur 1 zeigt eine flexible Leiterbahnfolie 1, welche eine erste Kreisfläche 2, eine zweite Kreisfläche 3 und einen Steg 4 bildet, welcher die beiden Kreisflächen 2 und 3 einstückig miteinander verbindet. Die Kreisfläche 3 ist ein Schaltungsträger, auf welchem, nur beispielhaft und schematisch dargestellt, ein integrierter Schaltkreis 5 und ein weiteres elektrisches Bauelement 6 angeordnet sind. Damit soll lediglich gezeigt werden, dass der Schaltungsträger 3 elektrische und elektronische Bauelemente trägt. Der integrierte Schaltkreis (IC) 5 enthält in seinem Gehäuse einen Drucksensor. Zu diesem Zweck hat das Gehäuse des IC 5 eine Öffnung 14, siehe Figur 2, die durch einen Filter 7 abgedeckt ist.

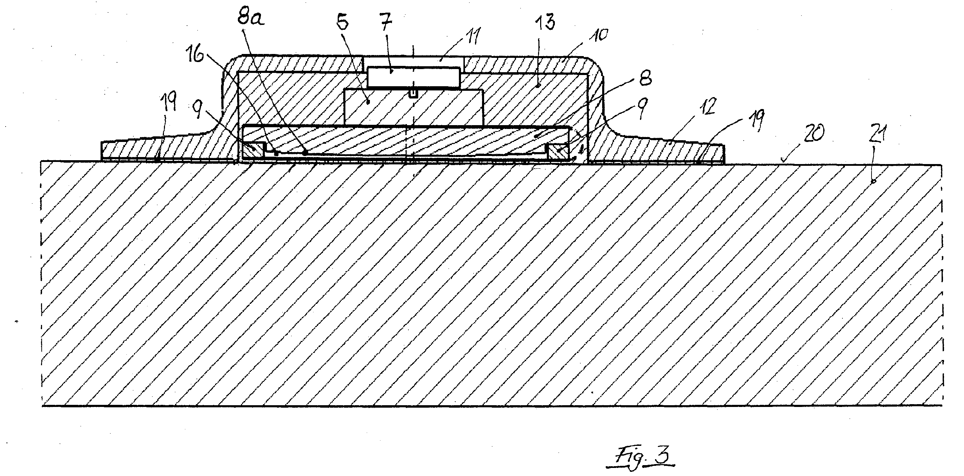

Unter dem Schaltungsträger 3 ist eine kreisförmige Scheibe 8 aus einem starren Kunststoff angeordnet, deren Unterseite 8a konvex gewölbt ist. Unter der Kunststoffscheibe 8 ist ein kompressibler Dichtring 9 vorgesehen, dessen Profil einen rechteckigen Querschnitt hat. Zum Zusammenbauen des Reifenmoduls wird der Schaltungsträger 3, welcher mit den elektrischen und elektronischen Bauelementen bestückt ist, auf die Oberseite der Kunststoffscheibe 8 gelegt. Der Dichtring 9 wird an die Unterseite der Kunststoffscheibe 8 gelegt und die Kreisfläche 2 der Leiterbahnfolie 1 wird nach oben gegen den Dichtring 9 geschwenkt, wodurch zwischen der konvexen Unterseite 8a der Kunststoffscheibe 8 und der Kreisfläche 2 ein von dem Dichtring 9 begrenzter, abgeschlossener Freiraum 16 geschaffen wird. Auf der in Figur 1 nicht sichtbaren Unterseite der Kreisfläche 2 befinden sich eine Piezoscheibe 17 und darunter eine Metallscheibe 18, siehe Figuren 2 und 3.

Die Bestandteile des Reifenmoduls werden mit einer Vergussmasse 13 vergossen und nach deren Verfestigung en bloc in eine Kappe 10 gesteckt, welche in ihrer Oberseite eine Öffnung 11 hat, in welche der Filter 7 eingreift. Die Kappe 10 hat einen nach außen vorspringenden Rand 12, mit welchem sie auf der Innenseite 20 eines Reifens 21 befestigt werden kann, siehe Figur 3.

Figur 2 zeigt, wie das mit der Vergussmasse 13 vergossene Reifenmodul in der Kappe 10 sitzt. Die verfestigte Vergussmasse 13 hat eine im wesentlichen zylindrische Umfangsfläche 13a, welche gegenüber der lichten Weite der leeren Kappe 10 ein Übermaß hat, so dass die Kappe 10 das Reifenmodul unter mechanischer Vorspannung aufnimmt. Damit sich die Kappe 10 dehnen kann, besteht sie aus einem elastomeren Werkstoff, insbesondere auf Kautschukbasis.

In Figur 2 sieht man von den Bauelementen auf dem Schaltungsträger 3 lediglich den IC 5. Weitere Bauelemente sind aus Gründen der Vereinfachung nicht mit eingezeichnet worden. Im Gehäuse des IC 5 ist die Lage der Öffnung 14 angegeben, durch welche der zum Beispiel im IC 5 vorgesehene Drucksensor mit der im Reifen vorhandenen Druckluft beaufschlagt werden kann.

Man sieht in der Schnittdarstellung der Figur 2, dass die Unterseite der Kunststoffscheibe 8 am Rand mit einer Ringschulter 15 versehen ist, an welcher der Dichtring 9 liegt. Der Dichtring 9 ist eine radiale Begrenzung des Freiraums 16, welcher sich zwischen der Kunststoffplatte 8 und der darunter liegenden ersten Kreisfläche 2 der Leiterbahnfolie 1 befindet. An der Unterseite der ersten Kreisfläche 2 ist eine Piezoscheibe 17 angeordnet, welche vorzugsweise aus einer Piezokeramik besteht. Unter der Piezoscheibe 17 ist eine vorzugsweise kreisförmige Metallscheibe 18 befestigt. Die Metallscheibe 18 besteht mit Vorteil aus einer Nickel-Eisen-Legierung mit 42 Gew.-% Nickel. Sie kann z. B. mittels eines Leitklebers mit der Piezoscheibe 17 verbunden sein. Ein Leitkleber ist ein Kleber, der elektrisch leitfähige Pigmente enthält, die dem Kleber eine elektrische Leitfähigkeit verleihen.

Der Durchmesser der Metallscheibe 18 ist größer als der Durchmesser der Piezoscheibe, aber nicht größer als der Durchmesser der beiden Kreisflächen 2 und 3.

An der Unterseite des Flansches 12 der Kappe 10 ist ein Haftvermittler 19 vorgesehen, z. B. ein Hot-melt. Mit diesem kann die Kappe 10 mitsamt dem eingesetzten Reifenmodul, wie in Figur 3 dargestellt, auf die Innenseite 20 eines nur schematisch und ausschnittweise dargestellten Reifen 21 geklebt werden. Eine alternative Befestigungsmöglichkeit ist das Aufvulkanisieren des Flansches 12 auf die Innenseite 20 des Reifens 21.

Figur 3 zeigt, dass das Reifenmodul einschließlich der ausgehärteten Vergussmasse 13, in welche es eingebettet ist, in der Höhe etwas Übermaß gegenüber der lichten Höhe der Kappe 10 hat und im Durchmesser etwas Übermaß gegenüber dem Innendurchmesser der Kappe 10 hat. Beim Verbinden des Flansches 12 mit der Innenseite 20 des Reifens 21 wird das Reifenmodul unter Dehnung der Kappe 10 in diese hineingedrückt und ist darin allseits spielfrei gehalten. Zugleich wird durch das Übermaß in der Höhe die Metallscheibe 18 gegen die Innenseite 20 des Reifens 21 gedrückt. Die Metallscheibe 18 ist so dünn und biegsam, dass sie sich der Krümmung der Innenseite 20 des Reifens 21 anpasst. Wenn der Latsch des Reifens 21 den Bereich durchläuft, in welchem das Reifenmodul am Reifen 21 angebracht ist, ändert sich unter der Metallscheibe 18 die Krümmung der Innenseite 20 des Reifens 21 und mit ihr die Krümmung der Metallscheibe 18 und der Piezoscheibe 17, wodurch eine Piezospannung erzeugt wird.

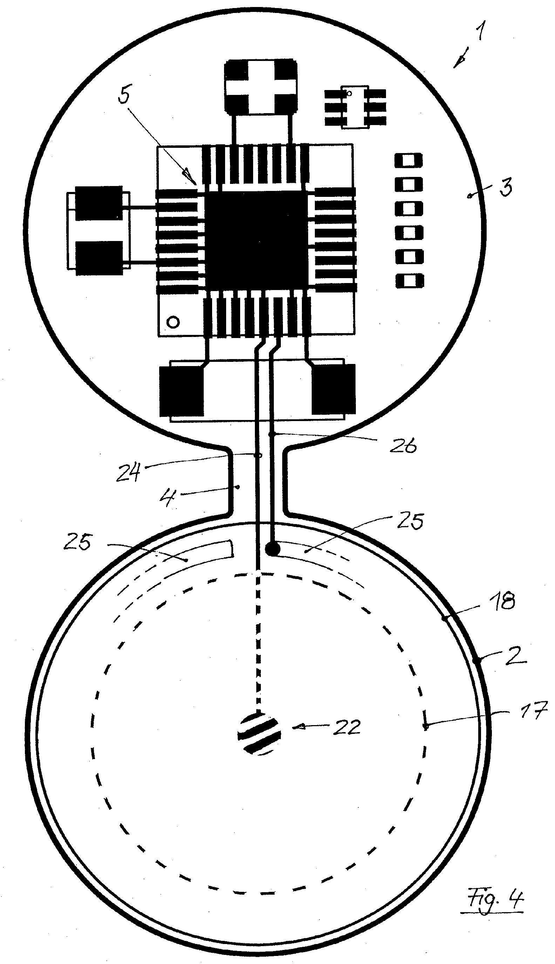

Figur 4 zeigt die aufgeklappte Leiterbahnfolie 1, welche die erste Kreisfläche 2 und die zweite Kreisfläche 3 bildet, welche in einem Stück durch den Steg 4 miteinander verbunden sind. Die Leiterbahnfolie 1 ist flexibel und wird deshalb auch als Flexfolie bezeichnet. Auf der Kreisfläche 2 ist die Piezoscheibe 17 angeordnet. Die Piezoscheibe 17 ist durch die kreisförmige Metallscheibe 18 verdeckt und deshalb nur gestrichelt gezeichnet. Die Piezoscheibe 17 und die Metallscheibe 18 sind koaxial zur Kreisfläche 2 angeordnet. Der Durchmesser der Metallscheibe 18 ist nur wenig kleiner als der Durchmesser der Kreisfläche 2. Der Durchmesser der Piezoscheibe 17 ist kleiner als der Durchmesser der Metallscheibe 18.

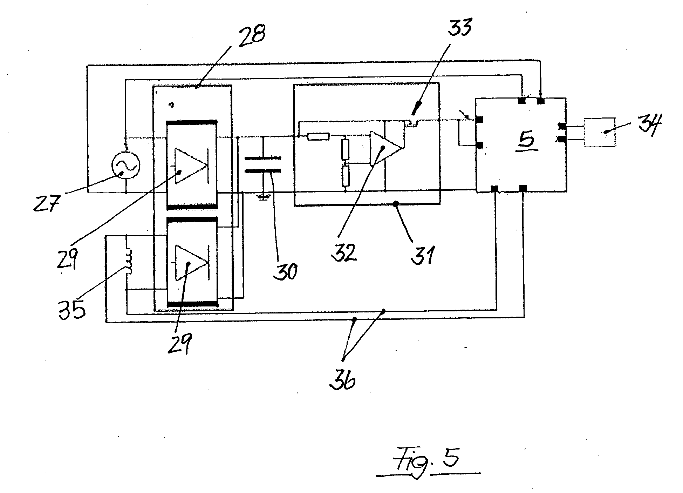

Die Metallscheibe 18 ist z. B. mittels eines elektrisch leitfähigen Klebers mit der Piezoscheibe 17 verbunden und stellt mit der ersten Seite der Piezoscheibe 17 einen vollflächigen elektrischen Kontakt her. Die zweite Seite der Piezoscheibe 17 ist mit Hilfe der Leiterbahnfolie 1 elektrisch kontaktiert. Im mittleren Bereich der Piezoscheibe 17 ist eine Kontaktstelle 22 angeordnet. Anstelle der einen Kontaktstelle 22 können im mittleren Bereich der Piezoscheibe 17 auch mehrere Kontaktstellen angeordnet sein, welche durch Leiterbahnen der Leiterbahnfölie 1 untereinander verbunden und gemeinsam durch eine Leiterbahn 24 der Leiterbahnfolie 1 mit einem Eingang des integrierten Schaltkreises 5 verbunden sind. Die Metallscheibe 18 ist entlang eines Kreisbogens, welcher in der Nähe des Randes der Metallscheibe 18 verläuft und sich über einen Umfangswinkel von etwas weniger als 360° erstreckt, mit einer Leiterbahn 25 verlötet und durch eine Leiterbahn 26 der Leiterbahnfolie 1 mit einem weiteren Eingang des integrierten Schaltkreises 5 verbunden. Auf diese Weise wird die an der Piezoscheibe 17 auftretende Piezo-Spannung an den integrierten Schaltkreis 5 und - in Figur 4 nicht dargestellt - über einen Gleichrichter 28 an einen Kondensator oder dergleichen Speicher 30 für elektrische Energie übertragen, siehe Figur 5.

Auf der Metallplatte 18 sind die beiden Leiterbahnen 24 und 26 durch elektrisch isolierenden Lack voneinander isoliert.

Die auf der Kreisfläche 3 der Leiterbahnfolie 1 dargestellten Bauelemente sind lediglich schematisch und ohne ihre funktionellen Verbindungen dargestellt, nur um zu zeigen, dass es sich bei der Kreisfläche 3 um einen Schaltungsträger handelt.

Figur 5 ist ein vereinfachtes Schaltbild des Reifenmoduls. Es zeigt den piezoelektrisch arbeitenden mechanisch-elektrischen Wandler 27, im wesentlichen bestehend aus der Piezoscheibe 17, der Metallscheibe 18 auf der einen und der Kreisfläche 2 der Leiterbahnfolie 1 auf der anderen Seite der Piezoscheibe 17. Der Wandler 27 ist einerseits direkt mit zwei Eingängen des integrierten Schaltkreises 5 und andererseits mit einem Gleichrichter 28 verbunden, der mehrere Dioden, z. B. acht Dioden enthält, von denen zwei Dioden 29 dargestellt sind. Der Gleichrichter 28 speist einen Speicher 30 für elektrische Energie, bei dem es sich im vorliegenden Fall um einen Kondensator handelt. Der Speicher 30 ist über eine Steuerschaltung 31, welche die Stromversorgung steuert (im englischen Sprachgebrauch eine Power Management Unit PMU), mit dem integrierten Schaltkreis 5 verbunden. Die Steuerschaltung 31 enthält einen Komparator 32, welcher den Ladezustand des Speichers 30 mit einem Grenzwert vergleicht und - bei Überschreiten des Grenzwerts - den integrierten Schaltkreis 5 über einen Feldeffekttransistor 33 mit Strom versorgt. Der integrierte Schaltkreis 5 enthält unter anderem einen Drucksensor und steuert einen Sender 34, welcher hochfrequente Signale aussendet, die einen vom integrierten Schaltkreis 5 zur Verfügung gestellten Informationsgehalt haben, z. B. eine Angabe über den Reifendruck, eine Kennung, Angaben über den Reifen, seine Laufleistung etc.. Diese Signale können z. B. mit einer Frequenz von 433 MHz übertragen werden.

Die Schaltung enthält ferner eine Empfangsantenne, insbesondere eine magnetische Antenne, dargestellt als eine Wicklung 35, welche für relativ niederfrequente Signale empfänglich ist, beispielsweise für Signale von 125 KHz. Diese Signale können einerseits verwendet werden, um Steuersignale und Daten an den integrierten Schaltkreis 5 zu übertragen, wozu die Wicklung 35 über Leitungen 36 mit zwei Eingängen des integrierten Schaltkreises 5 verbunden ist. Die von der Wicklung 35 empfangenen niederfrequenten Signale können aber auch benutzt werden, um den Speicher 30 aufzuladen. In diesem Fall werden die Signale dem Gleichrichter 28 zugeführt.

Der Speicher 30 ist so ausgelegt, dass seine Ladung für mehrere Mess- und Sendevorgänge ausreicht, wenn er vollständig aufgeladen wurde. Die Mess- und Sendevorgänge können z. B. jeweils dann ausgelöst werden, wenn der Ladezustand des Speichers 30 einen vorgegebenen Grenzwert überschreitet. Da der mechanisch-elektrische Wandler 27 bei jeder Radumdrehung eine bestimmte Ladungsmenge für den Speicher 30 zur Verfügung stellt, kann auf diese Weise mit zunehmender Geschwindigkeit häufiger gemessen und gesendet werden. Die Häufigkeit der Mess- und Sendevorgänge kann aber vom integrierten Schaltkreis 5 beschränkt werden, wenn der Ladezustand niedrig ist, um nicht unnötig häufig zu messen und zu senden.

Bei langsamer Fahrt oder im Stillstand, wenn der Grenzwert des Ladezustands unterschritten wird, kann die Steuerschaltung 31 den integrierten Schaltkreis 5 abschalten. Wenn der Ladezustand des Speichers 30 den vorgegebenen Grenzwert des Ladezustandes des Speichers 30 wieder überschreitet, kann der integrierte Schaltkreis 5 wieder aktiviert werden und seine Mess- und Sendevorgänge wieder aufnehmen.

Der mechanisch-elektrische Wandler 27 liefert bei jedem Durchgang durch den Latsch des Reifens zwei markante elektrische Impulse von unterschiedlicher Polarität. Daraus kann der integrierte Schaltkreis 5 zwischen Stillstand und Fahrt unterscheiden und die Geschwindigkeit des Fahrzeugs erkennen. Bei höheren Geschwindigkeiten wird dem Speicher 30 so viel elektrische Energie zugeführt, dass nicht nur regelmäßig, z. B. alle 10 Sekunden, der Reifendruck gemessen und gesendet werden kann, sondern auch noch charakteristische Daten des Reifens übertragen werden können, insbesondere eine Reifenkennung, ein Reifentyp und eine kumulierte Anzahl von Umdrehungen als ein Maß für seine Laufleistung.

Aus dem zeitlichen Abstand der beiden markanten Impulse, die beim Latschdurchlauf erzeugt werden, kann die Latschlänge bestimmt werden. Das ist ein wichtiger Sicherheitsaspekt, weil die Latschlänge nicht nur vom Füllgrad des Reifens abhängt, sondern auch von der Beladung des Fahrzeugs. Mit zunehmender Beladung nimmt die Latschlänge zu. Eine unzulässig hohe Beladung kann durch Auswerten der gemessenen Latschlänge erkannt und dem Fahrer signalisiert werden. Die Ermittlung der Latschlänge ist auch deshalb von Bedeutung, weil sie mitbestimmend ist für den Verschleiß, welchem der Reifen unterliegt.

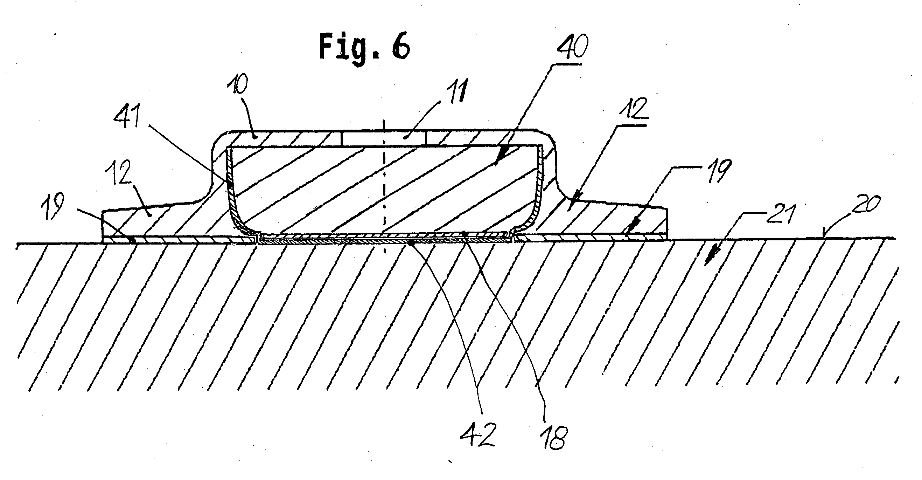

Bei dem in Figur 6 dargestellten Ausführungsbeispiel sind gleiche oder einander entsprechende Teile mit den gleichen Bezugszahlen bezeichnet wie in den vorhergehenden Figuren.

Das in Figur 6 dargestellte Ausführungsbeispiel unterscheidet sich von den vorhergehenden Ausführungsbeispielen darin, dass das Reifenmodul 40 eine Wanne 41 hat, welche alle übrigen Bestandteile des Reifenmoduls 40 aufnimmt, welche der Einfachheit halber nicht einzeln dargestellt sind. Die Wanne 41 kann aus einer Kunststoffolie geformt sein, z. B. aus einem Polykarbonat. Ihr Boden 42 ist so dünn, dass er Verformungen der Lauffläche des Reifens 21, auf dessen Innenseite 20 der Boden 42 der Wanne 41 liegt, wenn das Reifenmodul 40 am Reifen 21 befestigt ist, problemlos mitmacht, so dass Verformungen der Innenseite 20 des Reifens 21 auf den mit der Piezoscheibe 17 gebildeten mechanisch-elektrischen Wandler übertragen werden. Das gewährleistet, dass der mechanisch-elektrische Wandler elektrische Energie erzeugt, welche im Reifenmodul 40 für dessen Betrieb gespeichert werden kann. Die Wanne 41 wird nicht mit der Innenseite 20 des Reifens 21 verklebt. Im Gegenteil ist es so, dass der Boden 42 der Wanne 41 bei Verformungen des Reifens 21 auf der Innenseite 20 des Reifens 21 gleiten kann. Zu diesem Zweck ist es günstig, für die Wanne 41 ein Material zu wählen, welches gegenüber der vorgegebenen Innenseite 20 des Reifens 21 einen möglichst niedrigen Haftreibungskoeffizienten und Gleitreibungskoeffizienten aufweist. Eine solche Wanne 41 kann auch in den anderen Ausführungsformen des erfindungsgemäßen Reifenmoduls verwendet werden.

**Bezugszahlenliste:**

| | | | |
|---|---|---|---|
| 1. | Leiterbahnfol ie | 31. | Steuerschaltung |
| 2. | erste Kreisfläche | 32. | Komparator |
| 3. | zweite Kreisfläche, Schaltungsträger | 33. | Feldeffekttransistor |
| 4. | Steg | 34. | Sender |
| 5. | integrierter Schaltkreis mit Drucksensor | 35. | Wicklung, Empfangsantenne |
| 6. | Bauelement | 36. | Leitung |
| 7. | Filter | 37. | |
| 8. | Distanzscheibe aus Kunststoff | 40. | Reifenmodul |
| 8a. | Unterseite von 8, konvexe Seite | 41. | Wanne |
| 9. | Dichtring | 42. | Boden der Wanne |
| 10. | Kappe | | |
| 11. | Öffnung in 10, Zugang | | |
| 12. | Flansch | | |
| 13. | Vergussmasse | | |
| 13a. | Umfangsfläche von 13 | | |
| 14. | Öffnung in 5, Zugang | | |
| 15. | Ringschulter | | |
| 16. | Freiraum | | |
| 17. | Piezoscheibe | | |
| 18. | Metallscheibe | | |
| 19. | Haftvermittler | | |
| 20. | Innenseite des Reifens | | |
| 21. | Reifen | | |
| 22. | Kontaktstelle | | |
| 23. | | | |
| 24. | Leiterbahn | | |
| 25. | Leiterbahn | | |
| 26. | Leiterbahn | | |
| 27. | Wandler | | |
| 28. | Gleichrichter | | |
| 29. | Dioden | | |
| 30. | Speicher | | |

## Patentansprüche

1. Reifenmodul zum Anbringen an einer Innenseite (20) eines Luft-Reifens (21) für Fahrzeuge,
mit einer Einrichtung (5) zum Messen und/oder Überwachen des Luftdrucks in dem Reifen,
mit einem Sender (34) zum Übertragen von Funksignalen, welche eine Information über den Luftdruck im Reifen (21) enthalten,
mit einem nlechanisch-elektrischen Wandler (17, 18, 2) mit einem biegbaren, kreisförmigen, scheibenförmigen piezoelektrischen Element (17), welches vom rollenden Reifen (21) verursachte wechselnde Formänderungen des piezoelektrischen Elementes (17) in elektrische Energie wandelt, nachfolgend als Piezoscheibe bezeichnet ist und an welcher eine durch den Piezo-Effekt erzeugte elektrische Spannung an Kontaktstellen abgegriffen wird,
und mit einem Speicher (30) für die elektrische Energie, welcher mit dem Wandler (17, 18, 2) verbunden ist,
**dadurch gekennzeichnet, dass** sich die Kontaktstellen auf gegenüberliegenden Seiten der Piezoscheibe (17) befinden, und dass die Piezoscheibe (17) im Reifenmodul so montiert ist, dass Formänderungen der Lauffläche des Luft-Reifens (21) Formänderungen der Piezoscheibe (17) erzeugen.

2. Reifenmodul nach Anspruch 1, **dadurch gekennzeichnet, dass** eine Kontaktstelle durch eine kreisförmige Metallscheibe (18) gebildet ist, welche eine erste Seite der Piezoscheibe (17) vollständig bedeckt und so dünn und biegsam ist, dass sie beim Durchlauf des Reifenmoduls durch den Latsch des Reifens (21) auftretende Verformungen des Reifens (1) auf die Piezoscheibe (17) übertragen kann.

3. Reifenmodul nach Anspruch 1 oder 2, **dadurch gekennzeichnet, dass** die zweite Seite der Piezoscheibe (17) nur teilweise mit wenigstens einer Kontaktstelle (22) versehen ist, vorzugsweise mit mehreren Kontaktstellen (22), welche elektrisch leitend miteinander verbunden sind,
dass die eine bzw. die mehreren Kontaktstellen (22) auf der zweiten Seite der Piezoscheibe (17) mittig angeordnet sind und höchstens 20%, vorzugsweise höchstens 10% der Oberfläche der zweiten Seite der Piezoscheibe (17) bedecken.

4. Reifenmodul nach einem der vorstehenden Ansprüche, **dadurch gekennzeichnet, dass** die Piezoscheibe (17) zwischen der Metallscheibe (18) auf der ersten Seite und einer flexiblen Leiterbahnfolie (1) auf der zweiten Seite der Piezoscheibe (17) angeordnet ist.

5. Reifenmodul nach Anspruch 4, **dadurch gekennzeichnet, dass** die Leiterbahnfolie (1), welche die erste Seite der Piezoscheibe (17) bedeckt, eine Kreisfläche (2) bildet, welche durch einen Steg (4), der vorzugsweise ebenfalls aus der Leiterbahnfolie besteht und vom Rand der Kreisfläche (2) ausgeht, mit einem Schaltungsträger (3) verbunden ist.

6. Reifenmodul nach Anspruch 5, **dadurch gekennzeichnet, dass** der Schaltungsträger (3) ebenfalls aus der Leiterbahnfolie (1) besteht, vorzugsweise eine Kreisfläche bildet und die beiden Kreisflächen (2, 3) durch den Steg (4) einstückig miteinander verbunden sind, im Durchmesser übereinstimmen und unter Zwischenfügen einer kreisförmigen Distanzscheibe (8) übereinander und vorzugsweise koaxial zueinander angeordnet sind.

7. Reifenmodul nach Anspruch 6, **dadurch gekennzeichnet, dass** die Distanzscheibe (8) auf ihrer der Piezoscheibe (17) zugewandten Seite konvex gewölbt ist.

8. Reifenmodul nach Anspruch 6 oder 7, **dadurch gekennzeichnet, dass** zwischen der Distanzscheibe (8) und der von der Leiterbahnfolie (1) gebildeten Kreisfläche (2), welche der Piezoscheibe (17) zugewandt ist, ein Dichtring (9) vorgesehen ist.

9. Reifenmodul nach Anspruch 7 oder 8, **dadurch gekennzeichnet, dass** die Bestandteile des Reifenmoduls, mit Ausnahme eines Freiraums (16) zwischen der konvexen Seite (8a) der Distanzscheibe (8) und der der konvexen Seite (8a) der Distanzscheibe (8) zugewandten Kreisfläche (2) sowie mit Ausnahme der der Piezoscheibe (17) abgewandten Seite der Metallscheibe (18) in eine elektrisch isolierende Vergussmasse (13) eingebettet sind, und dass die verfestigte Vergussmasse (13) vorzugsweise eine im wesentlichen zylindrische Umfangsfläche (13a) hat.

10. Reifenmodul nach Anspruch 9, **dadurch gekennzeichnet, dass** eine Kappe (10) vorgesehen ist, welche das vergossene Reifenmodul aufnimmt und einen Flansch (12) zum Verbinden der Kappe (10) mit der Innenseite (20) des Reifens (21) hat.

11. Reifenmodul nach Anspruch 10, **dadurch gekennzeichnet, dass** die Höhe des vergossenen Reifenmoduls unter Einbeziehung der verfestigten Vergussmasse (13), in welche das Reifenmodul eingebettet ist, gegenüber der lichten Höhe der leeren Kappe (10) ein Übermaß hat.

12. Reifenmodul nach einem der vorstehenden Ansprüche, **dadurch gekennzeichnet, dass** es als integralen Bestandteil eine Wanne (41) aufweist, welche die weiteren Bestandteile des Reifenmoduls (40) einschließlich einer Vergussmasse (13) aufnimmt.

13. Reifenmodul nach Anspruch 12, **dadurch gekennzeichnet, dass** die Wanne (41) aus einer Kunststofffolie geformt ist.

14. Reifenmodul nach Anspruch 12 oder 13, **dadurch gekennzeichnet, dass** die Wanne (41) einen Boden (42) hat, der so dünn ist, dass er die Verformung des Reifens (21) mitmacht und auf den mechanisch-elektrischen Wandler (17, 18, 2) überträgt, während dieser sich bei rollendem Reifen (21) an dessen Latsch vorbeibewegt.

15. Reifenmodul nach einem der Ansprüche 12 bis 14, **dadurch gekennzeichnet, dass** die Wanne (41) durch Tiefziehen einer Folie gebildet ist.

16. Luft-Reifen für Fahrzeuge, an dessen Innenseite (20) ein Reifenmodul nach einem der vorstehenden Ansprüche so befestigt ist, dass eine Verformung der Innenseite (20) des Luft-Reifens (21) eine reversible Verformung der Metallscheibe (18) und der Piezoscheibe (17) zur Folge hat.

17. Luft-Reifen nach Anspruch 16, **dadurch gekennzeichnet, dass** die Metallscheibe (18) der Innenseite (20) des Luft-Reifens (21) anliegt, vorzugsweise mit Druck.

18. Luft-Reifen nach Anspruch 12 und 16, **dadurch gekennzeichnet, dass** die Wanne (41) einen Boden (42) hat, welcher der Innenseite (20) des Reifens (21) anliegt, vorzugsweise mit Druck.

## Claims

1. A tyre module for attaching to an inside (20) of a pneumatic tyre (21) for motor vehicles,
with a device (5) for measuring and/or monitoring the air pressure in the tyre,
with a transmitter (34) for transmitting radio signals, which contain information regarding the air pressure in the tyre (21),
with a mechanical-electrical transducer (17, 18, 2) with a flexible, circular, disc-like piezo-electric element (17), which converts alternating changes in shape of the piezo-electric element (17) caused by the rolling tyre (21) into electric energy, hereinafter described as piezo disc, and on which an electrical voltage generated through the piezo effect is tapped off at contact points,
and with a storage unit (30) for the electric energy, which is connected to the transducer (17, 18, 2),
**characterized in that** the contact points are located on opposite sides of the piezo disc (17), and the piezo disc (17) is mounted in the tyre module in such a way that changes in shape of the tread of the pneumatic tyre (21) generate changes in shape of the piezo disc (17).

2. The tyre module according to Claim 1, **characterized in that** a contact point is formed through a circular metal disc (18), which completely covers a first side of the piezo disc (17) and is so thin and flexible that it can transmit to the piezo disc (17) deformations of the tyre (1) which occur during the passage of the tyre module through the contact patch of the tyre (21).

3. The tyre module according to Claim 1 or 2, **characterized in that** the second side of the piezo disc (17) is only partially provided with at least one contact point (22), preferentially with a plurality of contact points (22), which are connected to one another in an electrically conductive manner,
that the one or the plurality of the contact points (22) are arranged in the middle on the second side of the piezo disc (17) and cover a maximum of 20%, preferentially a maximum of 10%, of the surface of the second side of the piezo disc (17).

4. The tyre module according to any one of the preceding claims, **characterized in that** the piezo disc (17) is arranged between the metal disc (18) on the first side and a flexible conductor path film (1) on the second side of the piezo disc (17).

5. The tyre module according to Claim 4, **characterized in that** the conductor path film (1), which covers the first side of the piezo disc (17), forms a circular area (2), which is connected to a circuit substrate (3) by a web (4), which preferentially likewise consists of the conductor path film and originates from the edge of the circular area (2).

6. The tyre module according to Claim 5, **characterized in that** the circuit substrate (3) likewise consists of the conductor path film (1), preferentially forms a circular area, and the two circular areas (2, 3) are unitarily connected to one another by the web (4), coincide in this diameter and subject to the intermediate inserting of a circular spacer disc (8) are arranged on top of one another and preferentially coaxially to one another.

7. The tyre module according to Claim 6, **characterized in that** the spacer disc (8) on its side facing the piezo disc (17) is convexly curved.

8. The tyre module according to Claim 6 or 7, **characterized in that** between the spacer disc (8) and the circular area (2) formed by the conductor path film (1), which area (2) faces the piezo disc (17), a sealing ring (9) is provided.

9. The tyre module according to Claim 7 or 8, **characterized in that** the components of the tyre module, with the exception of a free space (16) between the convex side (8a) of the spacer disc (8) and the circular area (2) facing the convex side (8a) of the spacer disc (8) and with the exception of the side of the metal disc (18) facing away from the piezo disc (17), are embedded in an electrically insulating casting compound (13), and that the solidified casting compound (13) preferably has a substantially cylindrical circumferential surface (13a).

10. The tyre module according to Claim 9, **characterized in that** a cap (10) is provided, which receives the cast tyre module and has a flange (12) for connecting the cap (10) to the inside (20) of the tyre (21).

11. The tyre module according to Claim 10, **characterized in that** the height of the cast tyre module subject to including the solidified casting compound (13), in which the tyre module is embedded, has an oversize with respect to the clear height of the empty cap (10).

12. The tyre module according to any one of the preceding claims, **characterized in that** it has, as an integral part, a tub (41), which receives the further components of the tyre module (40) including a casting compound (13).

13. The tyre module according to Claim 12, **characterized in that** the tub (41) is moulded from a plastic foil.

14. The tyre module according to Claim 12 or 13, **characterized in that** the tub (41) has a bottom (42) which is so thin that it follows the deformation of the tyre (21) and transmits it to the mechanical-electrical transducer (17, 18, 2), while the latter with rolling tyre (21) moves past the contact patch of the tyre.

15. The tyre module according to any one of the Claims 12 to 14, **characterized in that** the tub (41) is formed through deep-drawing a foil.

16. A pneumatic tyre for vehicles, on the inside (20) of which a tyre module according to any one of the preceding claims is fastened in a way that a deformation of the inside (20) of the pneumatic tyre (21) results in a reversible deformation of the metal disc (18) and of the piezo disc (17).

17. The pneumatic tyre according to Claim 16, **characterized in that** the metal disc (18) contacts the inside (20) of the pneumatic tyre (21), preferentially with pressure.

18. The pneumatic tyre according to Claim 12 and 16, **characterized in that** the tub (41) has a bottom (42), which contacts the inside (20) of the tyre (21), preferentially with pressure.

## Revendications

1. Module de pneu destiné à être monté sur une face intérieure (20) d'un pneu (21) pour des véhicules,
avec un dispositif (5) de mesure et/ou de contrôle de la pression d'air dans le pneu,
avec un émetteur (34) de transmission de signaux par radio, lesquels contiennent une information concernant la pression d'air dans le pneu (21),
avec un convertisseur mécanique électrique (17, 18, 2) doté d'un élément piézoélectrique (17) pliable, de forme circulaire, en forme de disque, désigné par la suite par disque piézo et sur lequel est captée la tension électrique générée par l'effet piézo aux points de contact, lequel transforme les diverses variations de forme de l'élément piézoélectrique (17) occasionnées par le pneu (21) en rotation en énergie électrique,
et avec un accumulateur (30) pour l'énergie électrique, lequel est relié avec le convertisseur (17, 18, 2),
**caractérisé en ce que** les points de contacts se trouvent sur des côtés opposés du disque piézo (17), et que le disque piézo (17) est monté dans le module de pneu de telle façon que les variations de forme de la surface de roulement du pneu (21) génèrent des variations de forme du disque piézo (17).

2. Module de pneu selon la revendication 1, **caractérisé en ce qu**'un point de contact est formé par un disque métallique (18) de forme circulaire, lequel recouvre totalement une première face du disque piézo (17) et est si mince et pliable qu'il peut transmettre les déformations du pneu (1) révélées par la zone de contact du pneu (21) lors du passage du module de pneu vers le disque piézo (17).

3. Module de pneu selon les revendications 1 ou 2, **caractérisé en ce que** la seconde face du disque piézo (17) est munie uniquement partiellement d'au moins un point de contact (22), de préférence de plusieurs points de contact (22), lesquels sont reliés ensemble de manière conductrice du courant,
que le point, respectivement, les nombreux points de contact (22), sur la seconde face du disque piézo (17) sont disposés au centre et recouvrent au maximum 20 %, de préférence au maximum 10 %, de la surface de la seconde face du disque piézo (17).

4. Module de pneu selon l'une des revendications précédentes, **caractérisé en ce que** le disque piézo (17) est disposé entre le disque métallique (18) sur la première face et un film d'une piste conductrice (1) souple sur la seconde face du disque piézo (17).

5. Module de pneu selon la revendication 4, **caractérisé en ce que** le film de piste conductrice (1), lequel recouvre la première face du disque piézo (17) forme une surface circulaire (2), laquelle est reliée avec un support de circuit (3) par un pontage (4) qui est de préférence également constitué du film de piste conductrice et part du bord de la surface circulaire (2).

6. Module de pneu selon la revendication 5, **caractérisé en ce que** le support de circuit (3) est également constitué du film de piste conductrice (1), forme de préférence une surface circulaire et les deux surfaces circulaires (2, 3) sont reliées ensemble d'un seul tenant par le pontage (4), coïncident au niveau du diamètre et sont disposées superposées, et de préférence de manière coaxiale l'une par rapport à l'autre, moyennant l'insertion d'un disque d'espacement (8) de forme circulaire.

7. Module de pneu selon la revendication 6, **caractérisé en ce que** le disque d'espacement (8) est galbé de manière convexe sur sa face orientée vers le disque piézo (17).

8. Module de pneu selon les revendications 6 ou 7, **caractérisé en ce qu**'une bague d'étanchéité (9) est prévue entre le disque d'espacement (8) et le surface circulaire (2) formée par le film de piste conductrice (1), laquelle fait face au disque piézo (17).

9. Module de pneu selon les revendications 7 ou 8, **caractérisé en ce que** les composants du module de pneu, à l'exception d'un espace libre (16) entre la face convexe (8a) du disque d'espacement (8) et la surface circulaire (2) orientée vers la face convexe (8a) du disque d'espacement (8), ainsi qu'à l'exception de la face du disque métallique (18) opposée au disque piézo (17), sont incorporés dans une masse de scellement (13) isolante électriquement, et que la masse de scellement (13) solidifiée possède de préférence une surface circonférentielle (13a) substantiellement cylindrique.

10. Module de pneu selon la revendication 9, **caractérisé en ce qu'un** capuchon (10) est prévu, lequel recueille le module de pneu enrobé et a une patte (12) pour relier le capuchon (10) avec la face interne (20) du pneu (21).

11. Module de pneu selon la revendication 10, **caractérisé en ce que** la hauteur du module de pneu enrobé, en incluant la masse de scellement (13) solidifiée dans laquelle le module de pneu est incorporé, est démesurée par rapport à la légère hauteur du capuchon (10) vide.

12. Module de pneu selon l'une des revendications précédentes, **caractérisé en ce qu**'il comprend en tant que composant intégral une cuvette (41) laquelle recueille les autres composants du module de pneu (40) y compris une masse de scellement (13).

13. Module de pneu selon la revendication 12, **caractérisé en ce que** la cuvette (41) est formée dans une feuille de matière plastique.

14. Module de pneu selon les revendications 12 ou 13, **caractérisé en ce que** la cuvette (41) a un fond (42) qui est si fin qu'il participe à la déformation du pneu (21) et la transmet vers le convertisseur mécanique électrique (17, 18, 2) pendant que celui-ci passe à côté du pneu (21) en rotation au niveau de sa zone de contact.

15. Module de pneu selon l'une des revendications 12 à 14, **caractérisé en ce que** la cuvette (41) est formée par une zone de traction d'un film vers le bas.

16. Pneu pour véhicules, sur la face interne (20) duquel est fixé un module de pneu selon l'une des revendications précédentes, de telle sorte qu'une déformation de la face interne (20) du pneu (21) a pour conséquence une déformation réversible du disque métallique (18) et du disque piézo (17).

17. Pneu selon la revendication 16, **caractérisé en ce que** le disque métallique (18) est plaqué contre la face interne (20) du pneu (21), de préférence avec une pression.

18. Pneu selon les revendications 12 et 16, **caractérisé en ce que** la cuvette (41) possède un fond (42), lequel est plaqué contre la face interne (20) du pneu (21), de préférence avec une pression.
